# EUROPEAN PATENT APPLICATION

(11) **EP 4 571 836 A1**
(43) Date of publication of application: **18.06.2025**
(21) Application number: 23851658.7
(22) Date of filing: 02.08.2023
(51) Int. Cl.: H01L 27/06

(54) **SEMICONDUCTOR STRUCTURE AND METHOD FOR FORMING SAME**

(30) Priority: 12.08.2022 CN 202210964612
(71) Applicant: Changzhou Chemsemi Co., Ltd., Changzhou, Jiangsu 213166 (CN)
(72) Inventor: ZOU, Daohua, Changzhou, Jiangsu 213166 (CN); LIU, Yuwei, Changzhou, Jiangsu 213166 (CN); LI, Yuxin, Changzhou, Jiangsu 213166 (CN)
(74) Representative: Piticco, Lorena
(86) International application number: PCT/CN2023/110710
(87) International publication number: WO 2024/032437

(57) **Abstract**

A semiconductor structure and a method for forming same. The semiconductor structure comprises: a substrate, which comprises a first region; two or more capacitor structures, which are connected in parallel and are sequentially stacked on the first region in the direction perpendicular to the substrate, wherein a top edge region of at least one capacitor structure is provided with a protective layer, the protective layer being used for covering the top edge region of the capacitor structure, and thereby reducing the current which flows from a metal layer, which is located above the protective layer, to the edge region of the capacitor structure. By using the scheme, the capacity of a capacitor structure in a semiconductor structure can be increased without increasing the area of a device, and the reliability of the capacitor structure can be improved.

## Description

This application claims the benefit of priority to Chinese Patent Application No. 202210964612.7, filed on August 12, 2022 with China National Intellectual Property Administration, and entitled "SEMICONDUCTOR STRUCTURE AND METHOD FOR FORMING SAME", the entire disclosure of which is incorporated herein by reference.

### TECHNICAL FIELD

The present disclosure relates to the field of semiconductor technology, and particularly, to a semiconductor structure and a method for forming the same.

### BACKGROUND

When integrating a capacitor structure on a semiconductor substrate, the capacitor structure typically consists of an upper plate, a lower plate, and a dielectric layer disposed between the upper plate and the lower plate.

In practical applications, capacitance of the capacitor structure can be increased in the following three ways: 1) changing a dielectric constant of the dielectric layer; 2) change a thickness of the dielectric layer; and 3) increasing areas of the upper plate and the lower plate in the capacitor structure. Technically, a dielectric constant of a material is generally invariable; by changing material, the dielectric constant of the dielectric layer could be modified. In addition, the thickness of the dielectric layer is currently between 50 nm and 60 nm, and a thinner dielectric layer probably leads to a risk of breakdown.

Therefore, at present, the capacitance of the capacitor structure is increased mostly by means of increasing the areas of the upper plate and the lower plate in the capacitor structure. However, this means will increase area of an entire device, which does not comply with miniaturization of the device.

### SUMMARY

Embodiments of the present disclosure can increase capacitance of a capacitor structure in a semiconductor structure without increasing area of a device.

The embodiments of the present disclosure provide a semiconductor structure. The semiconductor structure includes: a substrate including a first area; and two or more capacitor structures coupled in parallel and stacked in the first area on the substrate along a direction perpendicular to the substrate;

wherein, at least one of the capacitor structures includes a protective layer in a top edge area thereof, and the protective layer covers the top edge area so as to reduce a current flow from a metal layer that is disposed above the protective layer to the top edge area.

According to some embodiments, the two or more capacitor structures include: a first capacitor structure disposed in the first area on the substrate; a second capacitor structure disposed above the first capacitor structure; and a first connection layer coupling the first capacitor structure and the second capacitor structure. The first capacitor structure includes a first bottom metal layer, a first dielectric layer and a first top metal layer stacked in order. The second capacitor structure includes a first top metal layer, a second dielectric layer and a second top metal layer stacked in order. The first connection layer electrically connects the first bottom metal layer and the second top metal layer.

According to some embodiments, the two or more capacitor structures include: a first capacitor structure disposed in the first area on the substrate; a second capacitor structure disposed above the first capacitor structure; and a first connection layer coupling the first capacitor structure and the second capacitor structure. The first capacitor structure includes a first bottom metal layer, a first dielectric layer and a first top metal layer stacked in order. The second capacitor structure includes a second bottom metal layer, a second dielectric layer and a second top metal layer stacked in order. The first connection layer electrically connects the first bottom metal layer and the second top metal layer.

According to some embodiments, the first dielectric layer includes a first via that exposes a surface of the first bottom metal layer, and the first connection layer passes through the first via, coupling the first bottom metal layer with the second top metal layer, so as to realize parallel connection of the first capacitor structure and the second capacitor structure.

According to some embodiments, the two or more capacitor structures further include: a third capacitor structure disposed above the second capacitor structure; and a second connection layer, wherein the third capacitor structure includes a third bottom metal layer, a third dielectric layer and a third top metal layer stacked in order, and the second connection layer electrically connects the first top metal layer and the third top metal layer.

According to some embodiments, the second dielectric layer includes a second via that exposes a surface of the first top metal layer, and the second connection layer passes through the second via, coupling the third top metal layer with the first top metal layer.

According to some embodiments, the protective layer includes a first protective layer covering an edge area of the second top metal layer, where the first protective layer covers the edge area of the second top metal layer and exposes the second via.

According to some embodiments, the protective layer includes a second protective layer. The second protective layer covers an edge area of the third top metal layer and exposes the second via. The second protective layer includes a third via that exposes a surface of the third top metal layer, and the second connection layer passes through the second via and the third via, coupling the third top metal layer with the first top metal layer.

According to some embodiments, an emitter structure, a base structure and a collector structure each share at least two of the metal layers with the two or more capacitor structures.

The embodiments of the present disclosure further provide a method for forming a semiconductor structure. The method includes: providing a substrate including a first area; and forming two or more capacitor structures in the first area on the substrate, the two or more capacitor structures are coupled in parallel and stacked in the first area on the substrate along a direction perpendicular to the substrate, and, at least one of the capacitor structures is formed comprising a protective layer in a top edge area thereof, where the protective layer covers the top edge area, so as to reduce a current flow from a metal layer that is disposed above the protective layer to the top edge area.

According to some embodiments, forming the two or more capacitor structures in the first area on the substrate includes: forming a first bottom metal layer, a first dielectric layer and a first top metal layer stacked in order in the first area on the substrate, and the first bottom metal layer, the first dielectric layer and the first top metal layer constitute a first capacitor structure; forming a second bottom metal layer, a second dielectric layer and a second top metal layer stacked in order on the first top metal layer, and the second bottom metal layer, the second dielectric layer and the second top metal layer constitute a second capacitor structure; and forming a first connection layer, coupling the first capacitor structure and the second capacitor structure in parallel.

According to some embodiments, forming the two or more capacitor structures in the first area on the substrate includes: forming a first bottom metal layer, a first dielectric layer and a first top metal layer stacked in order in the first area on the substrate, and the first bottom metal layer, the first dielectric layer and the first top metal layer constitute a first capacitor structure; forming a second dielectric layer and a second top metal layer stacked in order on the first top metal layer, and the first top metal layer, the second dielectric layer and the second top metal layer constitute a second capacitor structure; and forming a first connection layer, coupling the first capacitor structure and the second capacitor structure in parallel.

According to some embodiments, forming the first dielectric layer includes: forming a first initial dielectric layer; and forming a first via through the first initial dielectric layer, where the first via exposes a surface of the first bottom metal layer. Forming the first connection layer includes forming the first connection layer at a position where the first via is disposed, coupling the first bottom metal layer with the second top metal layer.

According to some embodiments, forming the two or more capacitor structures in the first area on the substrate further includes: forming a third bottom metal layer, a third dielectric layer and a third top metal layer stacked in order on the second top metal layer, and the third bottom metal layer, the third dielectric layer and the third top metal layer constitute a third capacitor structure; and forming a second connection layer coupling the first top metal layer and the third top metal layer.

According to some embodiments, forming the second dielectric layer includes: forming a second initial dielectric layer; and forming a second via through the second initial dielectric layer, and the second via exposes a surface of the first top metal layer. Forming the second connection layer includes: forming the second connection layer at a position where the second via is disposed, coupling the first top metal layer with the third top metal layer.

According to some embodiments, a first protective layer is formed before the third bottom metal layer is formed. The first protective layer covers an edge area of the second top metal layer and exposes the second via.

According to some embodiments, a second protective layer is formed after the third top metal layer is formed and before the second connection layer is formed. The second protective layer covers an edge area of the third top metal layer and exposes the second via. Further, the second protective layer includes a third via that exposes a surface of the third top metal layer. Forming the second connection layer includes: forming the second connection layer at a position where the second via and the third via are disposed, and the second connection layer couples the third top metal layer with the first top metal layer.

According to some embodiments, the substrate further includes a second area, and the method further includes forming a transistor structure in the second area on the substrate.

According to some embodiments, the transistor structure is a heterojunction bipolar transistor structure, and forming the transistor structure in the second area on the substrate includes forming an emitter structure, a base structure and a collector structure in the second area on the substrate.

According to some embodiments, at least one of the first top metal layer, the third top metal layer, the first connection layer and the second connection layer is formed in both the transistor structure and the capacitor structures.

According to some embodiments, at least one of the first protective layer and the second protective layer is formed in both the transistor structure and the capacitor structures.

The embodiments of the present disclosure have the following advantages.

In the embodiments of the present disclosure, the semiconductor structure includes two or more capacitor structures. The two or more capacitor structures are coupled in parallel, and capacitance of a capacitor in the semiconductor structure is thus increased. In addition, the two or more capacitor structures are stacked in order in the first area on the substrate along a direction perpendicular to the substrate, and capacitance of a capacitor in the semiconductor structure can be increased without occupying additional area by the capacitor structures.

Moreover, in the embodiments of the present disclosure, at least one of the capacitor structures includes a protective layer in a top edge area thereof. The protective layer covers the top edge area, and when a first metal layer is formed on the protective layer subsequently, contact area between the first metal layer and a second metal layer covered by the protective layer can be reduced, such that a current flow from the first metal layer to the top edge area of the second metal layer can be reduced to weaken discharge phenomenon caused thereby, and reliability of the capacitor structures is further improved.

### BRIEF DESCRIPTION OF THE DRAWINGS

Figures 1 to 6 are schematic views of an existing process for integrating a HBT and a capacitor structure on a same substrate.
Figure 7 is a schematic flow chart of a method for forming a semiconductor structure according to an embodiment of the present disclosure.
Figures 8 to 15 are schematic views of a process for integrating a HBT and capacitor structures on a same substrate according to an embodiment of the present disclosure.

### DETAILED DESCRIPTION

Currently, a transistor and a capacitor are typically integrated in a same wafer. As an example, the transistor is a Heterojunction Bipolar Transistor (HBT), and is integrated with the capacitor in the same wafer by a process as follows.

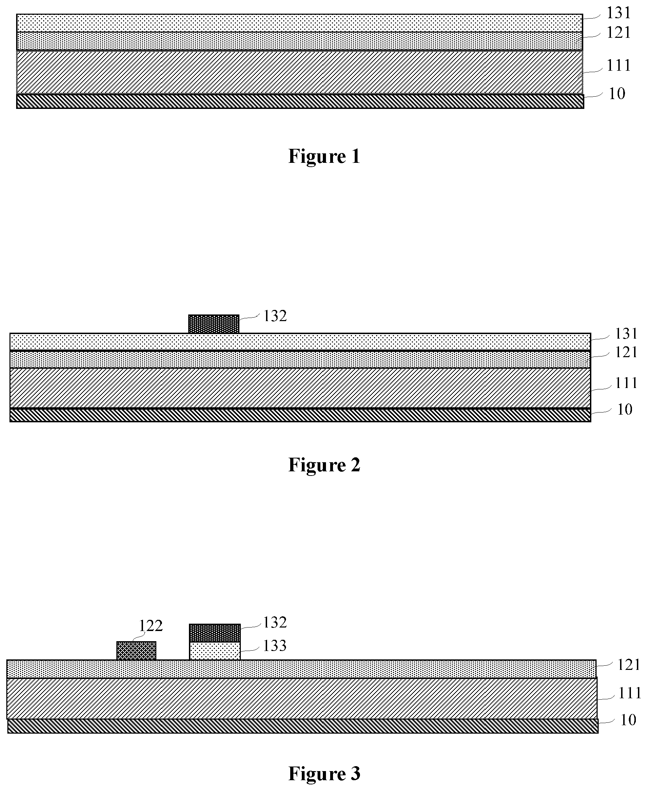

Please refer to Figure 1, an epitaxial structure of a wafer is formed. The epitaxial structure of the wafer includes a substrate 10, a collector layer 111, an initial base layer 121 and an initial emitter layer 131 from bottom to top.

Here, the collector layer 111 can be made of N-type gallium arsenide (GaAs) with a doping concentration of 10¹⁶/cm³, the initial base layer 121 can be made of P-type GaAs with a doping concentration of 10¹⁹/cm³, and the initial emitter layer 131 can be made of P-type GaAs with a doping concentration of 10¹⁷/cm³.

Please refer to Figure 2, an emitter ohmic contact electrode layer 132 is formed on the initial emitter layer 131.

Specifically, a layer of photoresist can be applied to the initial emitter layer 131 first to form a photoresist layer. The photoresist layer then goes through a process including oven, exposure, and development. Thereafter, the emitter ohmic contact electrode layer 132 may be formed on the initial emitter layer 131 by vapor deposition. The emitter ohmic contact electrode layer 132 can have a multi-layer structure including a titanium (Ti) film, a platinum (Pt) film, a Ti film, a Pt film and a Ti film stacked in order.

Please refer to Figure 3, the initial emitter layer 131 is etched to form an emitter layer 133. Then, a base ohmic contact electrode layer 122 is formed on the initial base layer 121.

For example, the initial emitter layer 131 can be etched after a photolithography process. The base ohmic contact electrode layer 122 can have a multi-layer structure including a Pt film, a Ti film, a Pt film, and a gold (Au) film stacked in order.

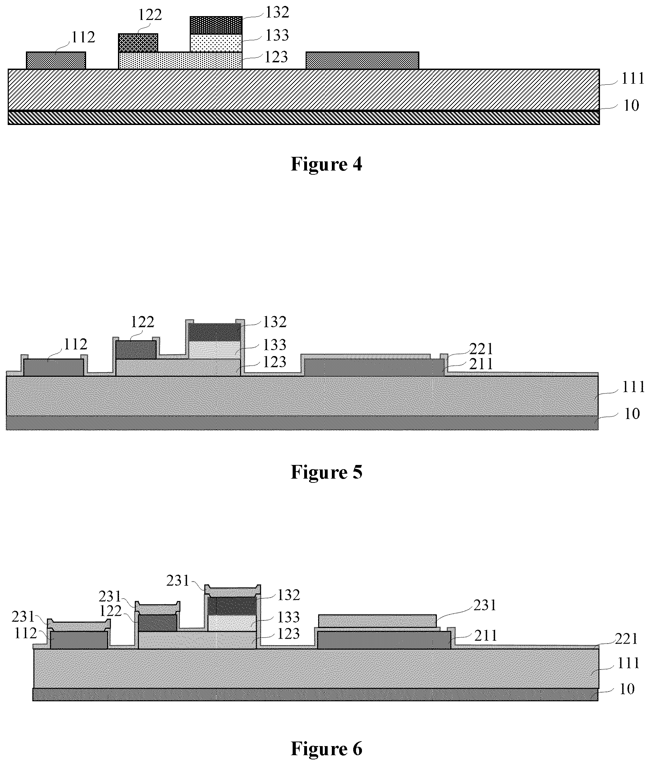

Please refer to Figure 4, the initial base layer 121 is etched to form a base layer 123. Then, as shown in Figure 5, a collector ohmic contact electrode layer 112 and a first bottom metal layer 211 are formed on an initial collector layer 111. And, the collector ohmic contact electrode layer 112 and the first bottom metal layer 211 can be formed either in a single step, or in two separate steps.

For example, a photolithography process is applied prior to etching the initial base layer 121, and then, the collector ohmic contact electrode layer 112 and the first bottom metal layer 211 may be formed by vapor deposition. Materials of the collector ohmic contact electrode layer 112 and the first bottom metal layer 211 can be Au.

The collector layer 111 and the collector ohmic contact electrode layer 112 constitute a collector structure of the HBT. The base layer 123 and the base ohmic contact electrode layer 122 constitute a base structure of the HBT. The emitter layer 133 and the emitter ohmic contact electrode layer 132 constitute an emitter structure of the HBT. The first bottom metal layer 211 acts as a lower plate of the capacitor.

As shown in Figure 5, a first dielectric layer 221 is formed. The first dielectric layer 221 covers the base structure, the emitter structure and the collector structure of the HBT, and serves as a passivation layer of the HBT to prevent side walls of the base structure, of the emitter structure and of the collector structure in the HBT from being oxidized.

Wherein, the first dielectric layer 221 may be deposited by a chemical vapor deposition method. The first dielectric layer 221 shall be drilled in an area so as to establish electrical conduction.

Please refer to Figure 6, a first top metal layer 231 is formed. The first top metal layer 231 covers the base structure, the emitter structure and the collector structure of the HBT, and serves as a passivation layer of the HBT to prevent side walls of the base structure, of the emitter structure and of the collector structure in the HBT from being oxidized. In a first area, the first top metal layer 231 further serves as an upper plate of the capacitor.

Wherein, the first top metal layer 231 may be formed through a process including exposure, vapor deposition, metal lift-off, and photoresist removal. The first top metal layer 231 is disposed above the first bottom metal layer 211 and is separated from the first bottom metal layer 211 by the first dielectric layer 221.

In the above semiconductor structure, the capacitor structure generally includes the first top metal layer 231, the first bottom metal layer 211, and the first dielectric layer 221 between the first top metal layer 231 and the first bottom metal layer 211.

In practical applications, capacitance of the capacitor structure can be increased in the following three ways: 1) changing a dielectric constant of the first dielectric layer 221; 2) change a thickness of the first dielectric layer 221; and 3) increasing areas of the upper plate and the lower plate in the capacitor structure, that is, increasing areas of the first top metal layer 231 and the first bottom metal layer 211.

Wherein, the dielectric constant of the first dielectric layer 221 is generally fixed at about 6.2, such that it is difficult to increase the capacitance of the capacitor structure by changing the dielectric constant of the dielectric layer. In addition, the thickness of the first dielectric layer 221 is currently between 50 nm and 60 nm, and will cause a risk of breakdown if further lowered.

Therefore, at present, the capacitance of the capacitor structure is increased mostly by means of increasing the areas of the upper plate and the lower plate in the capacitor structure, that is, increasing the areas of the first top metal layer 231 and the first bottom metal layer 211. However, this means will increase area of an entire device, which does not comply with miniaturization of the device.

The embodiments of the present disclosure provide a semiconductor structure. The semiconductor structure includes two or more capacitor structures. The two or more capacitor structures are coupled in parallel and stacked in order in the first area on the substrate along a direction perpendicular to the substrate. Since the two or more capacitor structures are stacked in order along the direction perpendicular to the substrate, additional area of the substrate occupied by the capacitor structures is not required. In addition, the two or more capacitor structures are coupled in parallel, such that capacitance of the semiconductor structure is increased, and capacitance of the capacitor structure in the semiconductor structure is thus increased without increasing area of the device. In addition, in the embodiments of the present disclosure, at least one of the capacitor structures includes a protective layer in a top edge area thereof. The protective layer covers the top edge area, so as to improve reliability of the capacitor structure.

In order to fulfill the above purposes, features and advantages of the present disclosure obvious and more understandable, specific embodiments of the present disclosure are described in detail below in conjunction with the accompanying drawings.

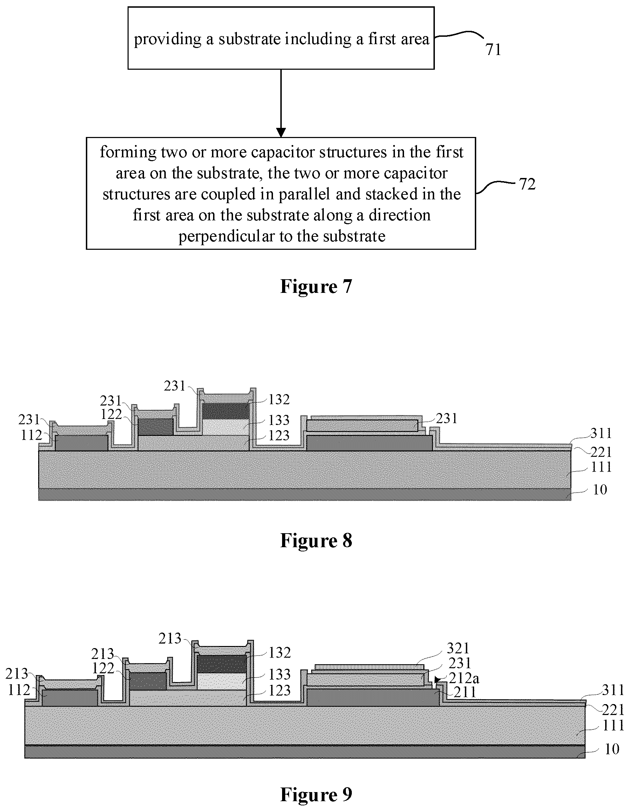

Please refer to Figure 7, the embodiments of the present disclosure provide a method for forming a semiconductor structure. The method may include the following steps.

Step 71. providing a substrate including a first area.

Step 72. forming two or more capacitor structures in the first area on the substrate, the two or more capacitor structures are coupled in parallel and stacked in the first area on the substrate along a direction perpendicular to the substrate.

Wherein, at least one of the capacitor structures is formed comprising a protective layer in a top edge area thereof, where the protective layer covers the top edge area, so as to reduce a current flow from a metal layer that is disposed above the protective layer to the top edge area.

Since the capacitors are coupled in parallel, capacitance of the capacitors in the semiconductor structure can be increased. In addition, the capacitor structures are stacked in order along the direction perpendicular to the substrate, such that the capacitor structures do not occupy additional area on the substrate, and area of the semiconductor structure cannot be increased, which complies with miniaturization of the device, as compared with Figure 6.

In some specific embodiments, the substrate may further include a second area. The method may further include forming a transistor structure in the second area on the substrate. And, the transistor structure may be a HBT or may also be a Complementary Metal Oxide Semiconductor (CMOS) transistor, and is not limited hereto.

In some specific embodiments, other device structures may be further formed in the second area on the substrate, as long as the device structures can be integrated on the same substrate with the capacitor structures.

As an example, a transistor structure is formed in the second area on the substrate, and the transistor structure is an HBT. Forming the transistor structure in the second area on the substrate may include forming an emitter structure, a base structure and a collector structure in the second area on the substrate.

A specific process for forming the HBT on the substrate can be implemented with reference to the above descriptions of Figures 1 to 6, and will not be repeated here.

In some specific embodiments, only two capacitor structures coupled in parallel can be formed in the first area on the substrate, and three or more capacitor structures coupled in parallel can also be formed in the first area on the substrate, and the specific number of the capacitor structures is not limited.

In an embodiment, only two capacitor structures coupled in parallel can be formed in the first area on the substrate, to serve as a first capacitor structure and a second capacitor structure, respectively. The first capacitor structure and the second capacitor structure can share a common metal layer, or do not share a common metal layer, that is, each has an independent metal layer.

In an embodiment of the present disclosure, when a thickness of the first top metal layer is greater than 150 nm (usually 1000 nm), it is indicated that the first top metal layer has a relatively thick thickness and can withstand relatively large current, so at this moment, the first capacitor structure and the second capacitor structure can be provided to share the first top metal layer. Correspondingly, forming two or more capacitor structures in the first area on the substrate may include:
forming a first bottom metal layer, a first dielectric layer and a first top metal layer stacked in order in the first area on the substrate, and the first bottom metal layer, the first dielectric layer and the first top metal layer constitute a first capacitor structure;
forming a second dielectric layer and a second top metal layer stacked in order on the first top metal layer, and the first top metal layer, the second dielectric layer and the second top metal layer constitute a second capacitor structure; and
forming a first connection layer coupling the first capacitor structure and the second capacitor structure in parallel.

As an example, the HBT is formed in the second area on the substrate. The capacitor structure formed in the first area on the substrate in Figure 6 is the first capacitor structure. As shown in Figure 6, when forming the first capacitor structure, the first bottom metal layer 211, the first dielectric layer 221 and the first top metal layer 231 are formed to be stacked in order in the first area on the substrate. The first dielectric layer 221 covers an upper surface of the first bottom metal layer 211, the first top metal layer 231 is disposed above the first bottom metal layer 211 and covers part of a surface of the first dielectric layer 221.

When forming the second capacitor structure, as shown in Figure 8, a second dielectric layer 311 can be formed on the first top metal layer 231 first. Please refer to Figure 9, after the second dielectric layer 311 is formed, a second top metal layer 321 covering a part of a surface of the second dielectric layer 311 can be formed above the first top metal layer 231. The first top metal layer 231, the second dielectric layer 311 and the second top metal layer 321 constitute the second capacitor structure.

Since the first capacitor structure and the second capacitor structure can share the common metal layer, so that manufacture process flow can be simplified while ensuring reliability of the capacitor structures.

In the embodiments shown in Figures 8 and 9, a thickness of the first bottom metal layer 211 ranges from 150 nm to 2000 nm.

In another embodiment of the present disclosure, when a thickness of the first top metal layer is less than or equal to 150 nm, it is indicated that the first top metal layer has a relatively thin thickness and can withstand limited current, so at this moment, the first capacitor structure and the second capacitor structure can be provided without sharing the first top metal layer. Forming the two or more capacitor structures in the first area on the substrate may include:
forming a first bottom metal layer, a first dielectric layer and a first top metal layer stacked in order in the first area on the substrate, and the first bottom metal layer, the first dielectric layer and the first top metal layer constitute a first capacitor structure;
forming a second bottom metal layer, a second dielectric layer and a second top metal layer stacked in order on the first top metal layer, and the second bottom metal layer, the second dielectric layer and the second top metal layer constitute a second capacitor structure; and
forming a first connection layer coupling the first capacitor structure and the second capacitor structure in parallel.

The first capacitor structure and the second capacitor structure cannot share a common metal layer, that is, the first capacitor structure and the second capacitor structure have two independent metal layers, respectively, such that reliability of the capacitor structures can be ensured.

In some specific embodiments, the second dielectric layer can be formed by applying a chemical vapor deposition method. The second dielectric layer may further be made of silicon nitride. Please refer to Figure 8, when forming the second dielectric layer 311, the second dielectric layer 311 can further cover side walls of the emitter structure, side walls of the collector structure and side walls of the base structure in the HBT, and thus serve as a passivation layer of the HBT to prevent oxidation of various structures in the HBT.

In some specific embodiments, a photoresist layer can be formed on the second dielectric layer first, and forming a layer of metal by vapor deposition. Then, a second top metal layer may be formed on the second dielectric layer following a process flow including vapor deposition, metal lift-off, photoresist removal, etc. Material of the second top metal layer may be the same as those of the first bottom metal layer and the first top metal layer.

In some specific embodiments, please refer to Figure 9, when a second top metal layer 321 is formed, the second top metal layer 321 can further cover the emitter structure, the collector structure and the base structure of the HBT, and a thickness of the metal layer on the emitter structure, the collector structure and the base structure in the HBT may be thus increased, so as to improve reliability of the transistor.

In some embodiments, the second dielectric layer and the second top metal layer may further be formed in the first area on the substrate.

In some specific embodiments, the first connection layer can couple the first capacitor structure and the second capacitor structure in parallel by applying a variety of means, which is not limited hereto.

In an embodiment of the present disclosure, please refer to Figure 9, a first via 212a through the first dielectric layer 221 can be formed, and then a first connection layer can be formed at a position where the first via 212a is disposed, such that the first bottom metal layer 211 is coupled with the second top metal layer 321. And, forming the first via 212a through the first dielectric layer 221 may include: forming the first initial dielectric layer; and forming the first via 212a through the first initial dielectric layer, and the first via 212a exposes a surface of the first bottom metal layer 211. At this moment, an end of the first connection layer can be electrically connected to a side wall of the second top metal layer 321, and another end of the first connection layer can be electrically connected to a surface of the first bottom metal layer 211. At this time, a side wall of the second top metal layer 321 is covered by the first connection layer.

In some specific embodiments, current flows to the first top metal layer 231 and the first bottom metal layer 211 sequentially from the second top metal layer 321. In order to avoid current flowing to edges of the metal layers, and in one embodiment, along the direction perpendicular to the substrate, effective areas of metal layers in the first capacitor structure and the second capacitor structure can be gradually reduced. Wherein, an effective area of a metal layer refers to an area in the current metal layer that can used to transmit current to a next metal layer, that is, an area where the current metal layer overlaps with a next metal layer.

Specifically, please refer to Figure 8, an effective area of the first bottom metal layer 211 is greater than that of the first top metal layer 231, and the effective area of the first top metal layer 231 is greater than that of the second top metal layer 321, such that a discharge phenomenon caused by current flowing to the edges of the metal layers can be minimized, and reliability of the capacitor structures is further improved.

In another embodiment of the present disclosure, three capacitor structures coupled in parallel can be formed in the first area on the substrate, that is, on the basis of the formed first capacitor structure and the second capacitor structure, a third capacitor structure is further formed on the second capacitor structure. Specifically, the method may further include:
forming a third bottom metal layer, a third dielectric layer and a third top metal layer stacked in order on the second top metal layer, and the third bottom metal layer, the third dielectric layer and the third top metal layer constitute a third capacitor structure; and
forming a second connection layer, and the second connection layer couples the first top metal layer with the third top metal layer.

It should be noted that, in some specific embodiments, the above steps can be used to form the third capacitor structure regardless of whether or not the first capacitor structure and the second capacitor structure share a common metal layer. Similar to the first capacitor structure and the second capacitor structure, the effective areas of metal layers in the third capacitor structure can be gradually reduced from bottom to top along the direction perpendicular to the substrate.

In some embodiments of the present disclosure, at least one of the capacitor structures includes a protective layer in a top edge area thereof. The protective layer covers the top edge area, so as to reduce a current flow from a metal layer that is disposed above the protective layer to the top edge area, to prevent the capacitor structure from a discharge phenomenon, so as to improve reliability of the capacitor structure.

In one embodiment of the present disclosure, the second top metal layer is usually relatively thin, has a thickness ranging from 100 nm to 500 nm, and can thus withstand relatively small current. Therefore, in order to further reduce the discharge phenomenon caused by a current flowing to edges of the second top metal layer and improve reliability of the capacitor structure, the first protective layer can be formed before the third bottom metal layer is formed. The first protective layer covers the top edge area of the second top metal layer and exposes the second via.

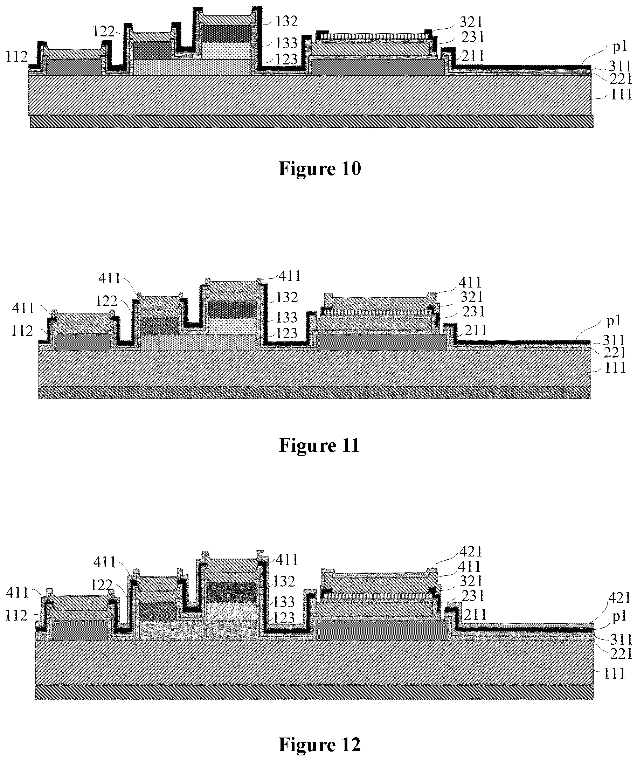

Specifically, as an example, the third capacitor structure is formed on the basis of Figure 9, please refer to Figure 10, after the second top metal layer 321 is formed, a first protective layer p1 can be formed first. The first protective layer p1 can cover the edge area of the second top metal layer 321. Thus, when a third bottom metal layer 411 is subsequently formed on the first protective layer p1, a contact area between the third bottom metal layer 411 and the second top metal layer 321 can be reduced. As a result, a current flowing from the third bottom metal layer 411 to the top edge area of the second top metal layer 321 can be avoided, and reliability of the capacitor structure can be improved.

In some embodiments, the first protective layer may also be formed only in the first area on the substrate and not formed on the HBT.

In some specific embodiments, the first protective layer p1 may be made of polymers, such as, polyimide. The first protective layer p1 has properties including insulation, high temperature resistance, waterproof and anti-oxidation, such that a current flow from the third bottom metal layer 411 to the top edge area of the second top metal layer 321 can be avoided. And, a thickness of the first protective layer p1 can be provided according to actual applications of the device, height difference of the device, reliability requirements, and other factors, and may be specifically between 500 nm to 5000 nm.

In some specific embodiments, the first protective layer p1 can further cover the second dielectric layer 311 and edge areas of the emitter structure, the collector structure and the base structure of the HBT, and can thus protect a corresponding device.

In some specific embodiments, the first protective layer p1 can be formed by means of either planarization coating or other process, which is not limited herein.

Please refer to Figure 11, after the first protective layer p1 is formed, the third bottom metal layer 411 can be formed on the first protective layer p1 and the second top metal layer 321.

Please refer to Figure 12, after the third bottom metal layer 411 is formed, a third dielectric layer 421 is formed on the formed third bottom metal layer 411.

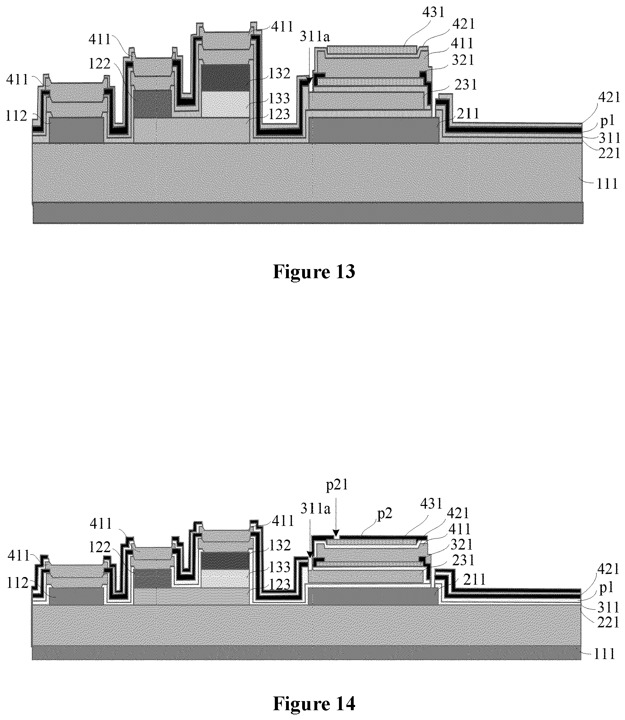

Please refer to Figure 13, after the third dielectric layer 421 is formed, a third top metal layer 431 is formed on the third dielectric layer 421.

In some specific embodiments, a process including vapor deposition, metal lift-off and photoresist removal can be used to form the third bottom metal layer 411 on the first protective layer p1 and to form the third top metal layer 431 on the third dielectric layer 421. Materials of the third bottom metal layer 411 and the third top metal layer 431 may be the same as the materials of the metal layers in the second capacitor structure and the first capacitor structure.

In some specific embodiments, a thickness of the third bottom metal layer 411 ranges from 1000 nm to 8000 nm, and a thickness of the third top metal layer 431 ranges from 100 nm to 500 nm.

In an embodiment, when the third bottom metal layer 411 is formed on the second top metal layer 321, the emitter structure, the collector structure and the base structure of the HBT can be also covered by the third bottom metal layer 411, to further increase thicknesses of the metal layers on the emitter structure, the collector structure and the base structure of the HBT and improve reliability of the transistor.

In some embodiments, the third bottom metal layer may also be formed in the first area on the substrate.

In some specific embodiments, please refer to Figure 13, the third dielectric layer 421 may be formed by a chemical vapor deposition method. Thickness ranges of the first dielectric layer 221, the second dielectric layer 321 and the third dielectric layer 421 can be provided according to device requirements, process capability, device reliability requirements, and other factors. In the embodiments of the present disclosure, the thickness ranges of the first dielectric layer 221, the second dielectric layer 321 and the third dielectric layer 421 may be the same, for example, 60 nm or 160 nm, which are within a range from 40 nm to 500 nm.

In some specific embodiments, the first dielectric layer 221, the second dielectric layer 321 and the third dielectric layer 421 may be made of a same material, for example, may all be made of silicon nitride or other materials.

In an embodiment of the present disclosure, the first connection layer and the second connection layer may be formed after the third top metal layer is formed. And, the first connection layer couples the first capacitor structure and the second capacitor structure, the second connection layer couples the first capacitor structure and the third capacitor structure.

In some specific embodiments, the first connection layer can couple the first capacitor structure and the second capacitor structure by directly coupling the first bottom metal layer with the second top metal layer. When the first protective layer is provided on the second top metal layer, because the first protective layer covers the second top metal layer and the second dielectric layer, the first connection layer may also indirectly couple the first bottom metal layer and the second top metal layer by coupling the third bottom metal layer with the first bottom metal layer, or by directly coupling the first top metal layer with the third bottom metal layer.

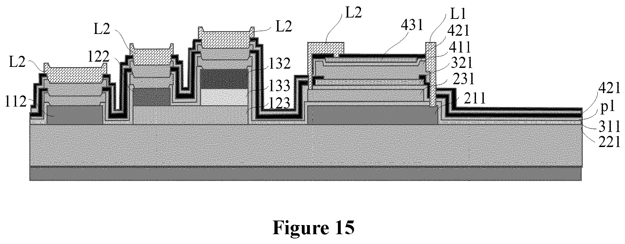

For example, as shown in Figure 15, an end of the first connection layer L1 is electrically connected with the first bottom metal layer 211 through a first via 212a (as shown in Figure 9) in the first dielectric layer 221, and the other end of the first connection layer L1 is electrically connected with the second top metal layer 321 through the third bottom metal layer 411.

In some specific embodiments, when the first connection layer couples the first bottom metal layer and the second top metal layer, or when the first connection layer couples the third bottom metal layer with the first bottom metal layer, the second connection layer may couple the first capacitor structure with the third capacitor structure by directly coupling the first top metal layer with the third top metal layer. When the first connection layer couples the first top metal layer with the third bottom metal layer, the second connection layer may couple the first capacitor structure with the third capacitor structure by coupling the first bottom metal layer with the third top metal layer.

For example, please refer to Figure 14, forming the second dielectric layer 311 may include: forming a second initial dielectric layer first, then forming a second via 311a through the second initial dielectric layer, and the second via 311a exposes a surface of the first top metal layer 231. Please refer to Figure 15, forming the second connection layer includes: forming the second connection layer L2 at a position where the second via 311a (as shown in Figure 14) is disposed, such that the first top metal layer 231 is coupled with the third top metal layer 431.

It should be noted that, in some specific embodiments, please refer to Figure 15, when a first via is formed through the first dielectric layer 221, beside the first connection layer L1, various layers above the first dielectric layer 221 expose the first via when they are formed. Similarly, when a second via is formed through the second dielectric layer 311, beside the second connection layer L2, various layers above the second dielectric layer 311 expose the second via when they are formed.

In some specific embodiments, please refer to Figure 15, the first connection layer L1 and the second connection layer L2 may be formed simultaneously. For example, the first connection layer L1 and the second connection layer L2 may be formed simultaneously through a process including vapor deposition, metal lift-off, photoresist removal. The first connection layer L1 and the second connection layer L2 may be made of gold (Au).

In some specific embodiments, please refer to Figure 15, while forming the first connection layer L1 and the second connection layer L2, the second connection layer L2 (or the first connection layer L1) may also be formed on the emitter structure, the collector structure and the base structure of the HBT, to increase thicknesses of the metal layers on the emitter structure, the collector structure and the base structure of the HBT, so as to improve reliability of the transistor.

In some embodiments, the first connection layer and the second connection layer may also be formed only in the first area on the substrate and not on the HBT.

In an embodiment of the present disclosure, please refer to Figures 14 and 15, a second protective layer p2 is formed after the third top metal layer 431 is formed and before the second connection layer L2 is formed. The second protective layer p2 can cover a top edge area of the third top metal layer 431 and expose the second via 311a. And, the second protective layer p2 includes a third via p21 that exposes a surface of the third top metal layer 431.

At this time, the second protective layer p2 can cover the top edge area of the third top metal layer 431, so as to avoid subsequent current flows to the top edge area of the third top metal layer 431 by passing the third top metal layer 431, which leads to a discharge phenomenon of the third top metal layer 431, so as to improve reliability of the capacitance. The second protective layer p2 can also cover a top edge area of the emitter structure, the collector structure and the base structure of the HBT, to prevent breakdown of the HBT, and improve reliability of the HBT. In addition, the second protective layer p2 can further cover most of area of the third top metal layer 431, and can further cover side walls of the emitter structure, the collector structure and the base structure of the HBT, to serve as a passivation layer, to prevent the third top metal layer 431 from being oxidized.

In some embodiments, the second protective layer may also be formed only in the first area on the substrate and not on the HBT.

In some specific embodiments, the second protective layer p2 and the first protective layer p1 may be made of a same material, for example, may be both made of polyimide. A thickness of the second protective layer p2 may range from 500 nm to 5000 nm, and can be adjusted according to actual applications, height difference of the device, reliability requirements, and other factors.

Please refer to Figures 14 and 15, after the second protective layer p2 is formed, forming the second connection layer L2 may include forming the second connection layer L2 at a position where the second via 311a and the third via p21 are disposed, and the second connection layer L2 couples the third top metal layer 431 and the first top metal layer 231.

It should be noted that the device formed in the second area on the substrate is not limited to the HBT, but may also be other devices, and the HBT is only an example of the device formed in the second area on the substrate.

It can be seen from the above that in the method for forming a semiconductor structure according to the embodiments of the present disclosure, the two or more capacitor structures coupled in parallel are formed at a same position on the substrate, as a result, capacitance of the capacitor in the semiconductor structure can be increased and no additional area on the substrate is required, which realizes a purpose of increasing the capacitance of the capacitor structures in the semiconductor structure without increasing an area of the device.

In addition, in the embodiments of the present disclosure, due to provision of the first protective layer, an edge area of the second capacitor structure can be covered, a contact area between the third bottom metal layer and the second top metal layer can be reduced, a current flow from the third bottom metal layer to the top edge area of the second top metal layer is avoided, and reliability of the capacitor is improved.

Furthermore, in the embodiments of the present disclosure, due to provision of the second protective layer, an edge area of the third capacitor structure can be covered, and an external current flowing to the top edge area of the third top metal layer can be avoided, so as to further improve reliability of the capacitor.

In order to enable those skilled in the art to better understand and realize the present disclosure, a semiconductor structure corresponding to the above method will be described in detail below.

The embodiments of the present disclosure provide a semiconductor structure. The semiconductor structure may include:
a substrate including a first area; and
two or more capacitor structures coupled in parallel and stacked in the first area on the substrate along a direction perpendicular to the substrate.

In an embodiment of the present disclosure, the substrate may further include a second area, in which a transistor structure may be disposed.

In an embodiment of the present disclosure, please refer to Figure 15, the transistor structure may be an HBT. The HBT may include: an emitter structure, a base structure and a collector structure disposed in the second area on the substrate.

In some specific embodiments, only two capacitor structures coupled in parallel may be disposed in the first area on the substrate, and, in other embodiments, three or more capacitor structures coupled in parallel may also be disposed in the first area on the substrate. The specific number of the capacitor structures is not limited.

In an embodiment of the present disclosure, please refer to Figure 15, three capacitor structures, which are respectively a first capacitor structure, a second capacitor structure and a third capacitor structure, coupled in parallel can be disposed in the first area on the substrate.

The first capacitor structure may include a first bottom metal layer 211, a first dielectric layer 221 and a first top metal layer 231 stacked in order.

The second capacitor structure may include the first top metal layer 231, a second dielectric layer 311 and a second top metal layer 321 stacked in order.

The first connection layer L1 couples the first top metal layer 231 and the second top metal layer 321.

In another embodiment of the present disclosure, only two capacitor structures, which are respectively a first capacitor structure and a second capacitor structure, coupled in parallel can also be disposed in the first area on the substrate. The first capacitor structure is disposed in the first area on the substrate, and the second capacitor structure is disposed above the first capacitor structure. The first capacitor structure and the second capacitor structure are coupled in parallel through the first connection layer.

In an embodiment, the first capacitor structure and the second capacitor structure may share a common metal layer.

Please refer to Figure 15, specifically, the first bottom metal layer 211, the first dielectric layer 221 and the first top metal layer 231 stacked in order constitute the first capacitor structure.

The first top metal layer 231, the second dielectric layer 311 and the second top metal layer 321 stacked in order constitute the second capacitor structure.

The first connection layer L1 couples the first top metal layer 231 and the second top metal layer 321.

At this time, the first capacitor structure and the second capacitor structure share the second top metal layer 321, that is, the second top metal layer 321 severs not only as an upper plate of the first capacitor structure, but also as a lower plate of the second capacitor structure, such that the manufacture process flow can be simplified while ensuring reliability of the capacitor structures.

In other embodiments, the first capacitor structure and the second capacitor structure may also not share a common metal layer.

Please refer to Figure 15, specifically, the first bottom metal layer 211, the first dielectric layer 221 and the first top metal layer 231 stacked in order constitute the first capacitor structure.

The second bottom metal layer (not shown), the second dielectric layer 311 and the second top metal layer 321 stacked in order constitute the second capacitor structure.

The first connection layer L1 couples the first top metal layer 231 and the second top metal layer 321.

In some specific embodiments, in order to couple the first top metal layer and the second top metal layer 321, the first dielectric layer 221 may have a first via 212a (see Figure 9) that exposes a surface of the first bottom metal layer 211. One end of the first connection layer L1 is electrically connected with the first bottom metal layer 211 through the first via 212a. The other end of the first connection layer L1 can be directly connected with the second top metal layer 321, and can also be indirectly coupled with the second top metal layer 321 through the third bottom metal layer 421.

In some specific embodiments, in order to couple the first top metal layer 231 with the third top metal layer 431, the second dielectric layer 311 may have a second via 311a (as shown in Figure 14) that exposes a surface of the first top metal layer 231. The second connection layer L2 is electrically connected with the third top metal layer 431 through the second via 311a. The second connection layer L2 may be directly connected with the third top metal layer 431.

In an embodiment of the present disclosure, please refer to Figure 15, the two or more capacitor structures may further include a first protective layer p1 covering a top edge area of the second top metal layer 321. The first protective layer p1 covers the top edge area of the second top metal layer 321 and exposes the second via 311a (as shown in Figure 14).

By providing the first protective layer p1, edge areas of the second capacitor structure can be covered, and a current flow from the third bottom metal layer 411 to the top edge area of the second top metal layer 321, which may result in breakdown of the second capacitor structure, can be reduced.

In another embodiment of the present disclosure, the two or more capacitor structures may further include a second protective layer p2. The second protective layer p2 covers a top edge area of the third top metal layer 411 and exposes the second via 311a (as shown in Figure 14). The second protective layer p2 includes a third via that exposes a surface of the third top metal layer 411. The second connection layer L2 couples the third top metal layer 411 with the first top metal layer 231 through the second via 311a and the third via.

By providing the second protective layer p2, edge areas of the third capacitor structure can be covered, and an external current flow to the top edge area of the third top metal layer 431, which may result in breakdown of the third capacitor structure, can be reduced.

In some specific embodiments, when forming the first top metal layer, the second top metal layer, the first connection layer and the second connection layer in the first area on the substrate, the abovemetal layers can be formed simultaneously on the emitter structure, the collector structure and the base structure of the HBT; alternatively, only a part of the above metal layers may be formed on the HBT, such that the emitter structure, the base structure and the collector structure of the HBT each include at least two metal layers in the two or more capacitor structures, so as to increase thicknesses of the metal layers in the HBT and improve reliability of the HBT.

In some specific embodiments, when forming the first protective layer p1 and the second protective layer p2, they may also be formed simultaneously on the emitter structure, the collector structure and the base structure of the HBT, such that the first protective layer p1 and the second protective layer p2 cover side walls and edge areas of the emitter structure, the collector structure and the base structure, so as to improve reliability of the HBT while protecting the HBT.

It can be seen from the above that in the semiconductor structure according to the embodiments of the present disclosure, the two or more capacitor structures are integrated in the same substrate, and since the two or more capacitor structures are coupled in parallel, capacitance of the capacitor in the semiconductor structure can be increased, and no additional area on the substrate is required, which realize a purpose of increasing the capacitance of the capacitor structures in the semiconductor structure without increasing an area of the device.

Although the present disclosure is disclosed as above, the present disclosure is not limited hereto. Various changes and modifications can be made by those skilled in the art without departing from the spirit and scope of the present disclosure. Therefore, the scope of protection of the present disclosure shall be subject to the scope limited by the claims.

## Claims

1. A semiconductor structure, **characterized by** comprising:
a substrate comprising a first area; and
two or more capacitor structures coupled in parallel and stacked in the first area along a direction perpendicular to the substrate,
wherein, at least one of the capacitor structures comprises a protective layer in a top edge area thereof, and the protective layer covers the top edge area, so as to reduce a current flow from a metal layer that is disposed above the protective layer to the top edge area.

2. The semiconductor structure according to claim 1, **characterized in that** the two or more capacitor structures comprise: a first capacitor structure disposed in the first area; a second capacitor structure disposed above the first capacitor structure; and a first connection layer coupling the first capacitor structure and the second capacitor structure, wherein,
the first capacitor structure comprises a first bottom metal layer, a first dielectric layer and a first top metal layer stacked in order;
the second capacitor structure comprises the first top metal layer, a second dielectric layer and a second top metal layer stacked in order;
the first connection layer electrically connects the first bottom metal layer and the second top metal layer.

3. The semiconductor structure according to claim 1, **characterized in that** the two or more capacitor structures comprise: a first capacitor structure disposed in the first area; a second capacitor structure disposed above the first capacitor structure; and a first connection layer coupling the first capacitor structure and the second capacitor structure, wherein,
the first capacitor structure comprises a first bottom metal layer, a first dielectric layer and a first top metal layer stacked in order;
the second capacitor structure comprises a second bottom metal layer, a second dielectric layer and a second top metal layer stacked in order;
the first connection layer electrically connects the first bottom metal layer and the second top metal layer.

4. The semiconductor structure according to claim 2 or 3, **characterized in that** the first dielectric layer comprises a first via that exposes a surface of the first bottom metal layer, and the first connection layer passes through the first via, coupling the first bottom metal layer with the second top metal layer.

5. The semiconductor structure according to claim 4, **characterized in that** the two or more capacitor structures further comprise: a third capacitor structure disposed above the second capacitor structure; and a second connection layer, wherein,
the third capacitor structure comprises a third bottom metal layer, a third dielectric layer and a third top metal layer stacked in order;
the second connection layer electrically connects the first top metal layer and the third top metal layer.

6. The semiconductor structure according to claim 5, **characterized in that** the second dielectric layer comprises a second via that exposes a surface of the first top metal layer, and the second connection layer passes through the second via, coupling the third top metal layer with the first top metal layer.

7. The semiconductor structure according to claim 6, **characterized in that** the protective layer comprises a first protective layer covering an edge area of the second top metal layer.

8. The semiconductor structure according to claim 6, **characterized in that** the protective layer comprises a second protective layer;
the second protective layer covers an edge area of the third top metal layer and exposes the second via;
the second protective layer comprises a third via that exposes a surface of the third top metal layer; and
the second connection layer passes through the second via and the third via, coupling the third top metal layer with the first top metal layer.

9. The semiconductor structure according to claim 1, **characterized in that** the substrate further comprises a second area with a transistor structure formed therein.

10. The semiconductor structure according to claim 9, **characterized in that** the transistor structure is a heterojunction bipolar transistor structure, and the heterojunction bipolar transistor structure comprises an emitter structure, a base structure and a collector structure disposed in the second area on the substrate.

11. The semiconductor structure according to claim 10, **characterized in that** the emitter structure, the base structure and the collector structure each comprises at least two of metal layers in the two or more capacitor structures.

12. A method for forming a semiconductor structure, **characterized by** comprising:
providing a substrate comprising a first area; and
forming two or more capacitor structures in the first area, the two or more capacitor structures are coupled in parallel and stacked in the first area on the substrate along a direction perpendicular to the substrate,
wherein, at least one of the capacitor structures is formed comprising a protective layer in a top edge area thereof, where the protective layer covers the top edge area, so as to reduce a current flow from a metal layer that is disposed above the protective layer to the top edge area.

13. The method for forming the semiconductor structure according to claim 12, **characterized in that** forming the two or more capacitor structures in the first area comprises:
forming a first bottom metal layer, a first dielectric layer and a first top metal layer stacked in order in the first area, and the first bottom metal layer, the first dielectric layer and the first top metal layer constitute a first capacitor structure;
forming a second bottom metal layer, a second dielectric layer and a second top metal layer stacked in order on the first top metal layer, and the second bottom metal layer, the second dielectric layer and the second top metal layer constitute a second capacitor structure; and
forming a first connection layer, coupling the first capacitor structure and the second capacitor structure in parallel.

14. The method for forming the semiconductor structure according to claim 12, **characterized in that** forming the two or more capacitor structures in the first area on the substrate comprises:
forming a first bottom metal layer, a first dielectric layer and a first top metal layer stacked in order in the first area, and the first bottom metal layer, the first dielectric layer and the first top metal layer constitute a first capacitor structure;
forming a second dielectric layer and a second top metal layer stacked in order on the first top metal layer, and the first top metal layer, the second dielectric layer and the second top metal layer constitute a second capacitor structure; and
forming a first connection layer, coupling the first capacitor structure and the second capacitor structure in parallel.

15. The method for forming the semiconductor structure according to claim 13 or 14, **characterized in that** forming the first dielectric layer comprises:
forming a first initial dielectric layer; and
forming a first via through the first initial dielectric layer, where the first via exposes a surface of the first bottom metal layer; and
forming the first connection layer comprises forming the first connection layer at a position where the first via is disposed, coupling the first bottom metal layer with the second top metal layer.

16. The method for forming the semiconductor structure according to claim 15, **characterized in that** forming the two or more capacitor structures in the first area on the substrate further comprises:
forming a third bottom metal layer, a third dielectric layer and a third top metal layer stacked in order on the second top metal layer, and the third bottom metal layer, the third dielectric layer and the third top metal layer constitute a third capacitor structure; and
forming a second connection layer coupling the first top metal layer and the third top metal layer.

17. The method for forming the semiconductor structure according to claim 16, **characterized in that** forming the second dielectric layer comprises:
forming a second initial dielectric layer; and
forming a second via through the second initial dielectric layer, and the second via exposes a surface of the first top metal layer; and
forming the second connection layer comprises: forming the second connection layer at a position where the second via is disposed, coupling the first top metal layer with the third top metal layer.

18. The method for forming the semiconductor structure according to claim 17, **characterized in that** a first protective layer is formed before the third bottom metal layer is formed, and the first protective layer covers an edge area of the second top metal layer and exposes the second via.

19. The method for forming the semiconductor structure according to claim 18, **characterized in that** a second protective layer is formed after the third top metal layer is formed and before the second connection layer is formed, and the second protective layer covers an edge area of the third top metal layer and exposes the second via; and the second protective layer comprises a third via that exposes a surface of the third top metal layer; and
forming the second connection layer comprises: forming the second connection layer at a position where the second via and the third via are disposed, and the second connection layer couples the third top metal layer with the first top metal layer.

20. The method for forming the semiconductor structure according to claim 19, **characterized in that** the substrate further comprises a second area, and the method further comprises:
forming a transistor structure in the second area.

21. The method for forming the semiconductor structure according to claim 20, **characterized in that** the transistor structure is a heterojunction bipolar transistor structure, and forming the transistor structure in the second area comprises:
forming an emitter structure, a base structure and a collector structure in the second area.

22. The method for forming the semiconductor structure according to claim 21, **characterized in that** at least one of the first top metal layer, the third top metal layer, the first connection layer and the second connection layer is formed in both the transistor structure and the capacitor structures.

23. The method for forming the semiconductor structure according to claim 21, **characterized in that** at least one of the first protective layer and the second protective layer is formed in both the transistor structure and the capacitor structures.
